# EUROPEAN PATENT APPLICATION

(11) **EP 4 618 145 A1**
(43) Date of publication of application: **17.09.2025**
(21) Application number: 25162943.2
(22) Date of filing: 11.03.2025
(51) Int. Cl.: H01L 23/498, H01L 23/538, H01L 21/48, H01L 23/31, H01L 23/00, H01L 25/065, H05K 5/00, H05K 5/02, H05K 9/00

(54) **SEMICONDUCTOR PACKAGE DEVICE AND METHOD OF MANUFACTURING THE SAME**

(30) Priority: 15.03.2024 KR 20240036124; 26.02.2025 KR 20250024716
(71) Applicant: Silicon Box Pte. Ltd., Singapore 529580 (SG)
(72) Inventor: HAN, Byung Joon, 06067 SEOUL (KR); HAN, Young Michael, NEW YORK, 10010 (US); AHN, Byung Hoon, 16941 GYEONGGI-DO (KR)
(74) Representative: Cabinet Beaumont

(57) **Abstract**

Disclosed are a semiconductor package device and a method of manufacturing the same. The semiconductor package device includes a circuit substrate unit including a plurality of conductive via elements extending in a vertical direction and a plurality of conductive pattern layer elements extending in a horizontal direction, a molding layer configured to form a single substrate shape along with the circuit substrate unit while filling the space around the circuit substrate unit, the molding layer being disposed so as to expose the circuit substrate unit, a redistribution layer member disposed on a first surface of a package substrate including the circuit substrate unit and the molding layer, and a plurality of chips mounted on the redistribution layer member so as to be electrically connected to the redistribution layer member.

## Description

### CROSS-REFERENCE TO RELATED APPLICATIONS

This application claims priority to Korean Patent Application No. 10-2024-0036124, filed on March 15, 2024, and Korean Patent Application No. 10-2025-0024716, filed on February 26, 2025, the entire contents of which are herein incorporated by reference.

### BACKGROUND OF THE INVENTION

### 1. Field of the invention

The present invention relates to semiconductor package-related technology and methods, and more particularly to a substrate for semiconductor packages, a semiconductor package device including the substrate, and a method of manufacturing the same.

### 2. Description of the Related Art

A semiconductor process may be divided into a front end process of manufacturing a wafer and engraving a circuit and a back-end process of packaging a chip. As semiconductor miniaturization technology approaches its limits, importance of the back-end process is further increasing. In this regard, advanced packaging technology that integrates different semiconductor chips or vertically connects a plurality of chips to each other is emerging as important technology. Recently developed artificial intelligence (AI) and high-performance computing (HPC) products may be constituted by a system-on-chip (SoC) such as a high bandwidth memory (HBM), a central processing unit (CPU), a neural processing unit (NPU), and a graphics processing unit (GPU).

2.5-dimensional (2.5D) packaging is packaging technology that integrates a plurality of semiconductor chips (dies) into a single package after horizontally disposing the plurality of semiconductor chips. 2.5D packaging is different from 3D packaging in that each chip is disposed on an interposer, which is a packaging part. A logic chip and a memory chip may be horizontally disposed on the interposer. Connecting chips through interconnect technology may improve connectivity between the chips.

Chip-on-wafer-on-substrate (CoWoS), a type of 2.5D packaging technology, means that two or more semiconductor chips are interconnected on a wafer and then disposed on a package substrate. The memory chip and the logic chip may be horizontally mounted on the interposer or may be vertically stacked on the interposer. In order to implement CoWoS, interposer (e.g., silicon interposer) technology that connects a plurality of chips like a single die is primarily used. The interposer is a type of substrate, but is characterized by only routing signals without any logic functions.

The interposer uses a through silicon via (TSV) or a through mold via (TMV) for electrical connection, and have a configuration that increases the ball pitch. In addition, in most cases, the interposer is used for interconnection of heterogeneous chips at the wafer level. However, all of these methods and processes have the disadvantages of being low in productivity, inefficient, and relatively high in production cost. In addition, 2.5D packaging technology using the conventional interposer has the limitations of being difficult to respond to various design changes and difficult to improve performance.

### SUMMARY OF THE INVENTION

It is an object of the present invention to provide a semiconductor package device capable of increasing cost-effectiveness and productivity and improving device performance and a method of manufacturing the same.

It is another object of the present invention to provide a semiconductor package device that is easy to respond to various design changes, is easy to manufacture, and is capable of securing excellent electrical performance and a method of manufacturing the same.

The objects of the present invention are not limited to the above objects, and other unmentioned objects will be understood by those skilled in the art based on the following description.

In accordance with one aspect of the present invention, the above and other objects can be accomplished by the provision of a semiconductor package device including a circuit substrate unit including a plurality of conductive via elements extending in a vertical direction and a plurality of conductive pattern layer elements extending in a horizontal direction, a molding layer configured to form a single substrate shape along with the circuit substrate unit while filling the space around the circuit substrate unit, the molding layer being disposed so as to expose the circuit substrate unit, a redistribution layer member disposed on a first surface of a package substrate including the circuit substrate unit and the molding layer, and a plurality of chips mounted on the redistribution layer member so as to be electrically connected to the redistribution layer member.

The circuit substrate unit may be a printed circuit board (PCB) unit including an organic substrate.

The circuit substrate unit may include the organic substrate, one or more first insulating layers disposed on a first surface of the organic substrate, and one or more second insulating layers disposed on a second surface of the organic substrate, the second surface being opposite the first surface, and a plurality of conductive via elements and a plurality of conductive pattern layer elements may be formed in and between the organic substrate, the one or more first insulating layers, and the one or more second insulating layers.

The circuit substrate unit may include at least one of at least one embedded passive device element and at least one embedded active device element.

The circuit substrate unit may include at least one of an antenna, a frequency filter, and a front end module (FEM) for communication.

A plurality of bumps may be provided on one surface of each of the plurality of chips, and the plurality of chips may be mounted on the redistribution layer member such that the plurality of bumps is electrically connected to the redistribution layer member.

The plurality of chips may include heterogeneous chips.

A plurality of electrical connection elements electrically connected to the circuit substrate unit may be disposed on a second surface of the package substrate, the second surface being opposite the first surface.

The semiconductor package device may further include a separate redistribution layer member disposed on a second surface of the package substrate, the second surface being opposite the first surface, and a plurality of electrical connection elements disposed on the separate redistribution layer member so as to be electrically connected to the separate redistribution layer member.

The semiconductor package device may further include at least one of at least one first passive device member disposed in the molding layer around the circuit substrate unit, the at least one first passive device member being electrically connected to the redistribution layer member, and at least one second passive device member disposed on a second surface of the package substrate, the second surface being opposite the first surface, so as to be electrically connected to the circuit substrate unit.

In accordance with another aspect of the present invention, there is provided a method of manufacturing a semiconductor package device, the method including providing a plurality of circuit substrate units each including a plurality of conductive via elements extending in the vertical direction and a plurality of conductive pattern layer elements extending in the horizontal direction, disposing the plurality of circuit substrate units on a carrier substrate so as to be spaced apart from each other in the horizontal direction, the plurality of circuit substrate units being disposed in each of a plurality of two-dimensionally disposed unit package areas, forming a molding layer configured to form a single substrate shape along with the plurality of circuit substrate units while filling spaces between and around the plurality of circuit substrate units on the carrier substrate, forming a redistribution layer member on a first surface of a package substrate including the plurality of circuit substrate units and the molding layer, mounting a plurality of chips on the redistribution layer member so as to be electrically connected to the redistribution layer member in each of the plurality of unit package areas, and dividing a device structure including the plurality of circuit substrate units, the molding layer, the redistribution layer member, and the plurality of chips, with the carrier substrate being excluded, into individual package devices corresponding to each of the plurality of unit package areas.

The circuit substrate unit may be a printed circuit board (PCB) unit including an organic substrate.

The circuit substrate unit may include the organic substrate, one or more first insulating layers disposed on a first surface of the organic substrate, and one or more second insulating layers disposed on a second surface of the organic substrate, the second surface being opposite the first surface, and a plurality of conductive via elements and a plurality of conductive pattern layer elements may be formed in and between the organic substrate, the one or more first insulating layers, and the one or more second insulating layers.

The circuit substrate unit may include at least one of at least one embedded passive device element and at least one embedded active device element.

The circuit substrate unit may include at least one of an antenna, a frequency filter, and a front end module (FEM) for communication.

A plurality of bumps may be provided on one surface of each of the plurality of chips, and the plurality of chips may be mounted on the redistribution layer member such that the plurality of bumps is electrically connected to the redistribution layer member.

The plurality of chips may include heterogeneous chips.

The method may further include forming a plurality of electrical connection elements electrically connected to the circuit substrate unit on a second surface of the package substrate, the second surface being opposite the first surface, in each of the plurality of unit package areas.

The method may further include forming a separate redistribution layer member on a second surface of the package substrate, the second surface being opposite the first surface, and forming a plurality of electrical connection elements electrically connected to the separate redistribution layer member on the separate redistribution layer member in each of the plurality of unit package areas.

The method may further include at least one of disposing at least one first passive device member on the carrier substrate around the circuit substrate unit in each of the plurality of unit package areas in the step of disposing the plurality of circuit substrate units on the carrier substrate and disposing at least one second passive device member electrically connected to the circuit substrate unit on a second surface of the package substrate, the second surface being opposite the first surface, in each of the plurality of unit package areas.

The method may further include removing the carrier substrate from the plurality of circuit substrate units and the molding layer between the step of forming the molding layer and the step of dividing the device structure into the individual package devices.

The method may further include forming an initial molding layer configured to cover the plurality of circuit substrate units and performing a grinding or ablation process on the initial molding layer to expose one surface of each of the plurality of circuit substrate units.

### BRIEF DESCRIPTION OF THE DRAWINGS

FIG. 1 is a sectional view illustratively showing a semiconductor package device according to an embodiment of the present invention;
FIG. 2 is a sectional view illustratively describing a circuit substrate unit that can be applied to the semiconductor package device according to the embodiment of the present invention;
FIG. 3 is a sectional view illustratively showing a semiconductor package device according to another embodiment of the present invention;
FIG. 4 is a sectional view illustratively describing a circuit substrate unit that can be applied to the semiconductor package device according to the other embodiment of the present invention;
FIG. 5 is a sectional view illustratively describing a circuit substrate unit that can be applied to the semiconductor package device according to the other embodiment of the present invention;
FIG. 6 is a sectional view illustratively showing a semiconductor package device according to yet another embodiment of the present invention;
FIG. 7 is a sectional view illustratively describing a circuit substrate unit that can be applied to the semiconductor package device according to the yet another embodiment of the present invention;
FIGs. 8A, 8B, 8C, 8D, 8E, 8F and 8G are sectional views illustratively showing a method of manufacturing a semiconductor package device according to an embodiment of the present invention;
FIGs. 9A, 9B, 9C, 9D, 9E, 9F and 9G are sectional views illustratively showing a method of manufacturing a semiconductor package device according to another embodiment of the present invention; and
FIGs. 10A, 10B, 10C, 10D, 10E, 10F, 10G and 10H are sectional views illustratively showing a method of manufacturing a semiconductor package device according to yet another embodiment of the present invention.

### DETAILED DESCRIPTION OF THE PREFERRED EMBODIMENTS

Hereinafter, embodiments of the present invention will be described in detail with reference to the accompanying drawings.

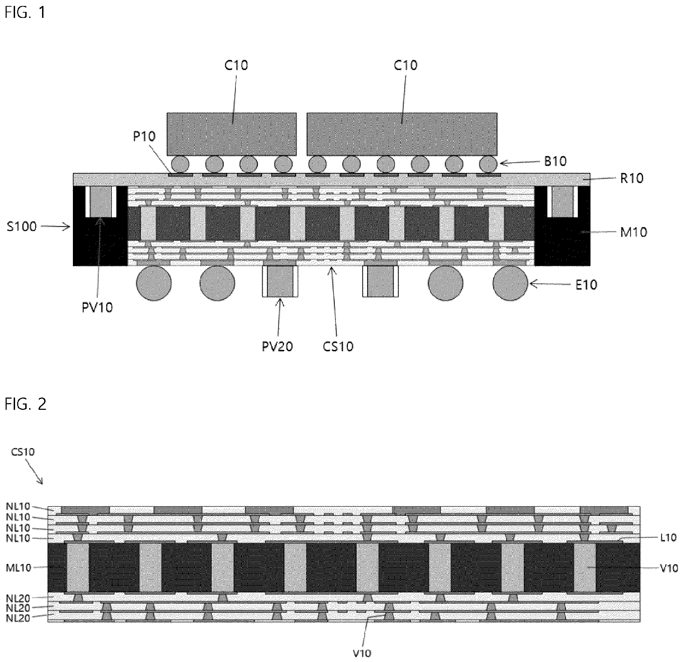

FIG. 1 is a sectional view illustratively showing a semiconductor package device according to an embodiment of the present invention.

Referring to FIG. 1, the semiconductor package device according to the embodiment of the present invention may include a circuit substrate unit CS. The circuit substrate unit CS10 may include a plurality of conductive via elements extending in a vertical direction and a plurality of conductive pattern layer elements extending in a horizontal direction. For example, the circuit substrate unit CS10 may be a printed circuit board (PCB) unit that includes an organic substrate. The circuit substrate unit CS10 may be manufactured through a PCB manufacturing process. The circuit substrate unit CS10 will be described in more detail later with reference to FIG. 2.

The semiconductor package device may include a molding layer M10 that forms a single substrate shape along with the circuit substrate unit CS10 while filling the space around the circuit substrate unit CS10. The molding layer M10 may be disposed so as to expose the circuit substrate unit CS10. For example, the molding layer M10 may expose an upper surface and a lower surface of the circuit substrate unit CS10. The molding layer M10 may have the same thickness or substantially the same thickness as the circuit substrate unit CS10, and may serve to fix the circuit substrate unit CS10 while wrapping around the circuit substrate unit CS10. The molding layer M10 may include a polymer material. For example, the molding layer M10 may include a molding compound.

The circuit substrate unit CS10 and the molding layer M10 may constitute a single package substrate S100. In other words, the package substrate S100 may include a circuit substrate unit CS10 and a molding layer M10.

The semiconductor package device may include a redistribution layer (RDL) member R10 disposed on a first surface of the package substrate S100. The first surface of the package substrate S100 may be any one of two main surfaces (an upper surface and a lower surface) of the package substrate S100. The redistribution layer member R10 may serve to redistribute an electrode pad array of the circuit substrate unit CS10. The redistribution layer member R10 may be formed through processes such as forming an insulating layer having a via hole (opening), forming a seed layer, forming a mask pattern, electroplating a wiring layer, and removing the mask pattern. Although the redistribution layer member R10 is simply shown in FIG. 1, the redistribution layer member R10 may include a structure in which an insulating layer (e.g., an organic insulating layer) and a wiring member layer (wiring element layer) are alternately stacked at least once. The insulating layer may have a plurality of via holes (openings) formed therein, and conductive via elements may be provided in the via holes. The conductive via element may serve as a vertical wire. The conductive via element may also be referred to as a "via-type wire" or a "via plug."

The redistribution layer member R10 may include a plurality of electrode pads P10 exposed on the surface thereof. The plurality of electrode pads P10 may be disposed on the opposite side of the package substrate S100, and may be disposed in two dimensions. At least some of the plurality of electrode pads P10 may be electrically connected to the circuit substrate unit CS10. The redistribution layer member R10 may serve to provide a plurality of electrode pads P10 with a fine pitch.

The semiconductor package device may include a plurality of chips C10 mounted on the redistribution layer member R10 so as to be electrically connected to the redistribution layer member R10. The plurality of chips C10 may be semiconductor chips, and may also be referred to as dies. According to an example, a plurality of bumps B10 may be provided on one surface of each of the plurality of chips C10. In other words, each of the plurality of chips C10 may include a plurality of bumps B10 disposed on one surface thereof. Each of the plurality of bumps B10 may be a micro bump, and may have at least a partial ball shape or other shapes. Each of the plurality of bumps B10 may be a type of electrical connection element. The plurality of chips C10 may be mounted on the redistribution layer member R10 such that the plurality of bumps B10 is electrically connected to the redistribution layer member R10. As the plurality of bumps B10 is connected to the plurality of electrode pads P10, the chip C10 may be electrically connected to the circuit substrate unit CS10 via the redistribution layer member R10.

According to an embodiment, the plurality of chips C10 may include heterogeneous chips. For example, the plurality of chips C10 may include a memory chip and a logic chip, and may further include other types of chips. The plurality of chips C10 may be disposed on the redistribution layer member R10 so as to be spaced apart from each other in the horizontal direction, and in some cases, one or more chips (i.e., dies) may be further stacked (mounted) on at least one of the plurality of chips C10. In the semiconductor package device according to the embodiment of the present invention, the package substrate S100 having the redistribution layer member R10 formed thereon may be a semiconductor package substrate having an interposer function, and may be used for a 2.5D package or a 3D package. According to the embodiment of the present invention, the heterogeneous chips may be easily connected to each other.

The semiconductor package device may further include a plurality of electrical connection elements E10 disposed on a second surface of the package substrate S100, which is opposite the first surface of the package substrate S100. Here, the second surface of the package substrate S100 may be any one of the two main surfaces (the upper surface and the lower surface) of the package substrate S100. The plurality of electrical connection elements E10 may be disposed so as to be electrically connected to or to be in electrical contact with the circuit substrate unit CS10. As a non-limiting example, each of the plurality of electrical connection elements E10 may include a solder ball or a bump. The plurality of electrical connection elements E10 may be connected to a predetermined circuit substrate (e.g., a motherboard) .

According to the embodiment of the present invention, the single package substrate S100 is constituted using the circuit substrate unit CS10 and the molding layer M10, the redistribution layer member R10 may be formed on the package substrate S100, and the plurality of chips C10 may be mounted on the redistribution layer member R10. The plurality of chips C10 may include two or more chips, and may be mounted, for example, using a flip-chip method. According to the embodiment of the present invention described above, it is possible to easily manufacture a semiconductor package substrate having a function of interconnecting the plurality of chips C10 and to improve the performance of the device and ease of design change. In this regard, according to the embodiment of the present invention, it is possible to implement a semiconductor package device capable of increasing cost-effectiveness and productivity and improving device performance and a method of manufacturing the same. In addition, according to the embodiment of the present invention, it is possible to implement a semiconductor package device that is easy to respond to various design changes, is easy to manufacture, and is capable of securing excellent electrical performance and a method of manufacturing the same.

According to an embodiment, the semiconductor package device may further include at least one of at least one first passive device member PV10 disposed in the molding layer M10 around the circuit substrate unit CS10 and electrically connected to the redistribution layer member R10 and at least one second passive device member PV20 disposed on the second surface of the package substrate S100, which is opposite the first surface of the package substrate S100, so as to be electrically connected to the circuit substrate unit CS10. The first and second passive device members PV10 and PV20 may be disposed outside the circuit substrate unit CS10, and therefore the first and second passive device members may be referred to as "outer passive devices." The first passive device member PV10 may be in contact with the redistribution layer member R10, and may be connected to at least one of the plurality of chips C10 via the redistribution layer member R10. The second passive device member PV20 may be attached to the second surface of the package substrate S100 together with the plurality of electrical connection elements E10 so as to be electrically connected to or in electrical contact with the circuit substrate unit CS10. As a non-limiting example, each of the first and second passive device members PV10 and PV20 may be a capacitor or may include a capacitor. The electrical performance of the semiconductor package device may be improved using at least one of the first and second passive device members PV10 and PV20.

FIG. 2 is a sectional view illustratively describing a circuit substrate unit CS10 that can be applied to the semiconductor package device according to the embodiment of the present invention.

Referring to FIG. 2, the circuit substrate unit CS10 may be a PCB unit including an organic substrate ML10. The organic substrate ML10 may include a polymer (plastic) material. The circuit substrate unit CS10 may include an organic substrate ML10, one or more first insulating layers NL10 disposed on a first surface of the organic substrate ML10 and one or more second insulating layers NL20 disposed on a second surface of the organic substrate ML10, which is opposite the first surface of the organic substrate ML10. The organic substrate ML10 may be referred to as a core material layer (intermediate material layer). The one or more first insulating layers NL10 may be stacked on one surface (first surface) of the organic substrate ML10, and the one or more second insulating layers NL20 may be stacked on the other surface (second surface) of the organic substrate ML10. The first and second insulating layers NL10 and NL20 may be organic material layers.

The circuit substrate unit CS10 may include a plurality of conductive via elements V10 and a plurality of conductive pattern layer elements L10 formed in and between the organic substrate ML10, the one or more first insulating layers NL10, and the one or more second insulating layers NL20. The plurality of conductive via elements V10 may extend in the vertical direction, and the plurality of conductive pattern layer elements L10 may extend in the horizontal direction. While the one or more first insulating layers NL10 and the one or more second insulating layers NL20 are stacked on the organic substrate ML10, the conductive via element V10 may be formed therein, and the conductive pattern layer element L10 may be formed therebetween. The plurality of conductive via elements V10 and the plurality of conductive pattern layer elements L10 may constitute various types of wiring. In addition, some of the conductive via elements V10 may be formed through the organic substrate ML10 or the circuit substrate unit CS10. The circuit substrate unit CS10 may have a plurality of via-type wiring elements extending in the vertical direction. The plurality of via-type wiring elements may have a shape that connects a lower surface and an upper surface of the circuit substrate unit CS10 to each other. The circuit substrate unit CS10 may be easily manufactured through the PCB manufacturing process.

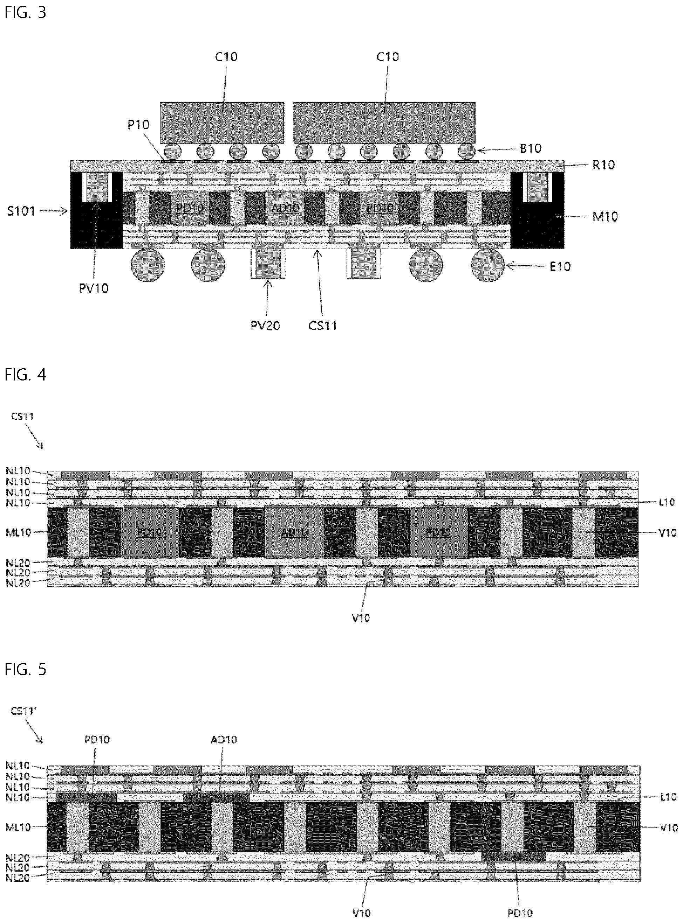

FIG. 3 is a sectional view illustratively showing a semiconductor package device according to another embodiment of the present invention.

Referring to FIG. 3, the semiconductor package device according to this embodiment may include a circuit substrate unit CS11. The circuit substrate unit CS11 may include a plurality of conductive via elements extending in the vertical direction and a plurality of conductive pattern layer elements extending in the horizontal direction. For example, the circuit substrate unit CS11 may be a PCB unit including an organic substrate. In this embodiment, the circuit substrate unit CS11 may include at least one embedded passive device element PD10 and/or at least one embedded active device element AD10. The circuit substrate unit CS11 may include both at least one embedded passive device element PD10 and at least one embedded active device element AD10. As a non-limiting example, the passive device element PD10 may include a capacitor, a resistor, an inductor, and an integrated passive device (IPD). As a non-limiting example, the active device element AD10 may include a transistor, a diode, an operational amplifier, and an integrated circuit (IC). Passive and active devices generally used in semiconductor devices may be employed. The circuit substrate unit CS10 may be pre-manufactured according to circuit substrate manufacturing technology.

The circuit substrate unit CS11 and a molding layer M10 may constitute a single package substrate S101. In other words, the package substrate S101 may include a circuit substrate unit CS11 and a molding layer M10. In FIG. 3, the configuration of the semiconductor package device may be identical or similar to the configuration of the semiconductor package device described with reference to FIG. 1 except for the circuit substrate unit CS11.

If the circuit substrate unit CS11 includes at least one embedded passive device element PD10 and/or at least one embedded active device element AD10, the electrical performance and functionality of the semiconductor package device may be further improved.

FIG. 4 is a sectional view illustratively describing a circuit substrate unit CS11 that can be applied to the semiconductor package device according to the other embodiment of the present invention.

Referring to FIG. 4, the circuit substrate unit CS11 may basically have a similar configuration to the circuit substrate unit CS10 described with reference to FIG. 2. The circuit substrate unit CS11 may include an organic substrate ML10, one or more first insulating layers NL10 disposed on a first surface of the organic substrate ML10, and one or more second insulating layers NL20 disposed on a second surface of the organic substrate ML10, which is opposite the first surface of the organic substrate ML10, and may include a plurality of conductive via elements V10 and a plurality of conductive pattern layer elements L10 formed in and between the organic substrate ML10, the one or more first insulating layers NL10, and the one or more second insulating layers NL20.

In addition, the circuit substrate unit CS11 may include at least one embedded passive device element PD10 and at least one embedded active device element AD10. For example, at least some of the passive device element PD10 and the active device element AD10 may be embedded in the organic substrate ML10. However, the positions where the passive device element PD10 and the active device element AD10 are formed/disposed are not limited to those shown and may be changed in various ways.

FIG. 5 is a sectional view illustratively describing a circuit substrate unit CS11' that can be applied to the semiconductor package device according to the other embodiment of the present invention.

Referring to FIG. 5, the circuit substrate unit CS11' may include at least one embedded passive device element PD10 and at least one embedded active device element AD10. At least some of the passive device element PD10 and the active device element AD10 may be embedded in the circuit substrate unit CS11' outside an organic substrate ML10.

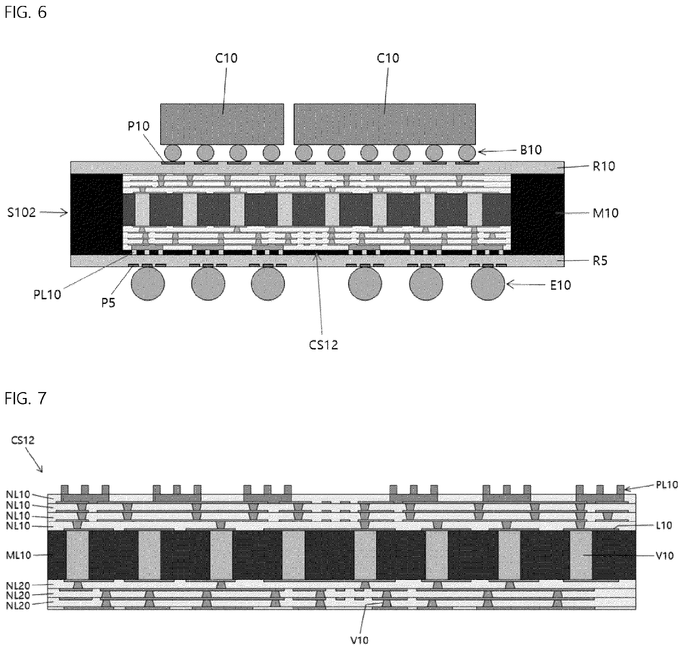

FIG. 6 is a sectional view illustratively showing a semiconductor package device according to yet another embodiment of the present invention.

Referring to FIG. 6, the semiconductor package device according to this embodiment may include a circuit substrate unit CS12. The circuit substrate unit CS12 may include a plurality of conductive via elements extending in the vertical direction and a plurality of conductive pattern layer elements extending in the horizontal direction. For example, the circuit substrate unit CS12 may be a PCB unit including an organic substrate. In this embodiment, the circuit substrate unit CS12 may include at least one of an antenna, a frequency filter, and a front end module (FEM) for communication. For example, the frequency filter may be a radio frequency (RF) filter; however, the present invention is not limited thereto. For example, the FEM for communication may be an RF front end module (FEM); however, the present invention is not limited thereto. The FEM for communication may include an antenna member and a frequency filter member. The antenna, the frequency filter, and the FEM for communication may be formed using device embedding technology or other device formation technologies. In addition, the circuit substrate unit CS12 may further include a plurality of conductive pillar elements PL10 formed on the surface (one surface) thereof. As a non-limiting example, the plurality of conductive pillar elements PL10 may include a metal, such as copper (Cu), or a metallic material. The circuit substrate unit CS12 may be pre-manufactured according to circuit substrate manufacturing technology.

A molding layer M10 may be formed so as to fill the spaces between and around the plurality of conductive pillar elements PL10, and an end of each of the plurality of conductive pillar elements PL10 may be exposed without being covered by the molding layer M10. Therefore, one surface of the circuit substrate unit CS12 having the plurality of conductive pillar elements PL10 formed thereon may be exposed by the molding layer M10.

The circuit substrate unit CS12 and the molding layer M10 may constitute a single package substrate S102. In other words, the package substrate S102 may include a circuit substrate unit CS12 and a molding layer M10.

A redistribution layer member R10 may be disposed on a first surface of the package substrate S102, and a plurality of chips C10 may be mounted on the redistribution layer member R10. A separate redistribution layer member R5 may be disposed on a second surface of the package substrate S102, which is opposite the first surface of the package substrate S102. The separate redistribution layer member R5 may be electrically connected to the circuit substrate unit CS12 via at least a plurality of conductive pillar elements PL10. The separate redistribution layer member R5 may include a plurality of electrode pads P5 exposed on the surface thereof. The plurality of electrode pads P5 may be disposed on the opposite side of the package substrate S102 and may be disposed in two dimensions. At least some of the plurality of electrode pads P5 may be electrically connected to the circuit substrate unit CS12.

A plurality of electrical connection elements E10 may be disposed on one surface of the separate redistribution layer member R5 so as to be electrically connected to the separate redistribution layer member R5. The plurality of electrical connection elements E10 may be disposed at the second surface of the package substrate S102. The plurality of electrical connection elements E10 may be connected to or in contact with the plurality of electrode pads P5. Even in the embodiment of FIG. 6, at least one of the first passive device member PV10 and the second passive device member PV20 described with reference to FIG. 1 may be further provided, as needed.

In this embodiment, if the circuit substrate unit CS12 includes at least one of an antenna, a frequency filter, and a FEM for communication, the electrical performance and functionality of the semiconductor package device may be further improved.

FIG. 7 is a sectional view illustratively describing a circuit substrate unit that can be applied to the semiconductor package device according to the yet another embodiment of the present invention.

Referring to FIG. 7, the circuit substrate unit CS12 may basically have a similar configuration to the circuit substrate unit CS10 described with reference to FIG. 2. The circuit substrate unit CS12 may include an organic substrate ML10, one or more first insulating layers NL10 disposed on a first surface of the organic substrate ML10, and one or more second insulating layers NL20 disposed on a second surface of the organic substrate ML10, which is opposite the first surface of the organic substrate ML10, and may include a plurality of conductive via elements V10 and a plurality of conductive pattern layer elements L10 formed in and between the organic substrate ML10, the one or more first insulating layers NL10, and the one or more second insulating layers NL20.

In addition, the circuit substrate unit CS12 may include at least one of an antenna, a frequency filter, and a FEM for communication. The antenna, the frequency filter, and the FEM for communication may be formed using device embedding technology or other device formation technologies. Additionally, the circuit substrate unit CS12 may further include a plurality of conductive pillar elements PL10 formed on the surface (one surface) thereof.

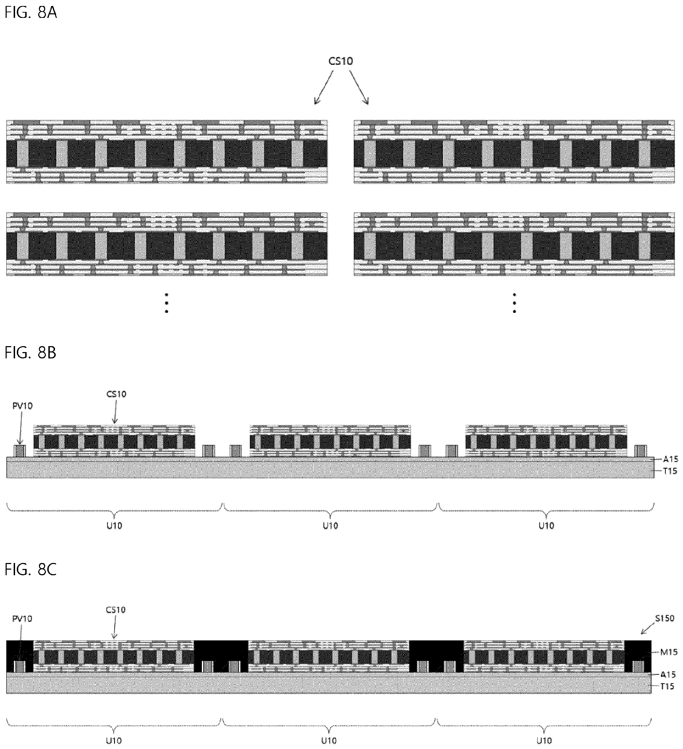

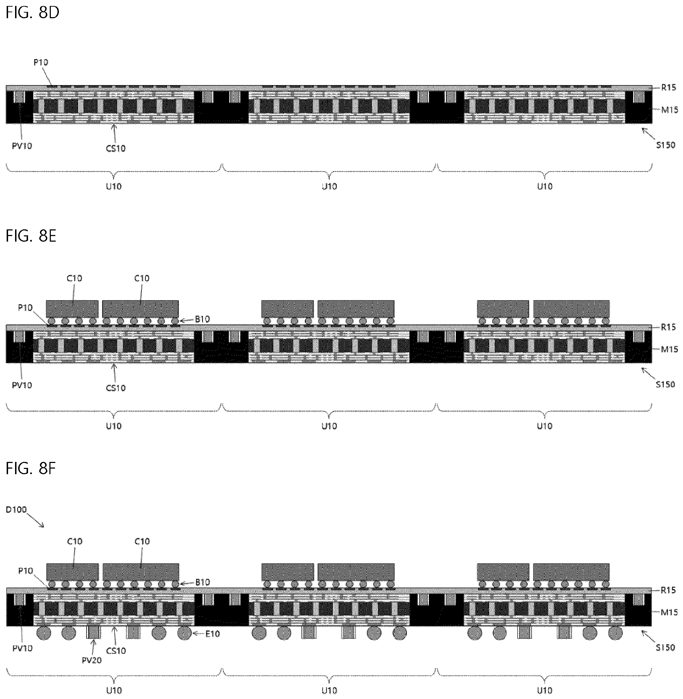

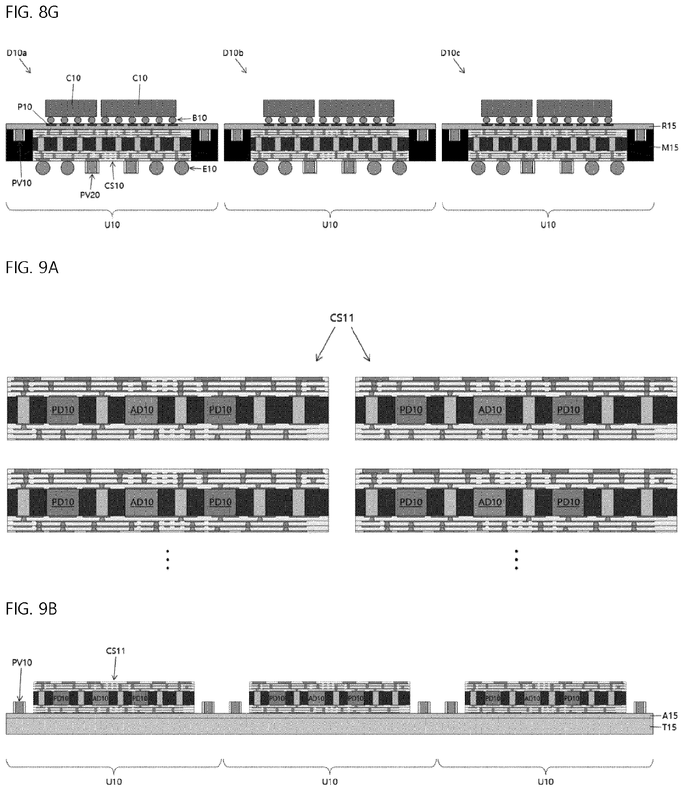

FIGs. 8A, 8B, 8C, 8D, 8E, 8F and 8G are sectional views illustratively showing a method of manufacturing a semiconductor package device according to an embodiment of the present invention.

Referring to FIG. 8A, a plurality of circuit substrate units CS10 may be provided. Each of the plurality of circuit substrate units CS10 may include a plurality of conductive via elements extending in the vertical direction and a plurality of conductive pattern layer elements extending in the horizontal direction. For example, the circuit substrate unit CS10 may be a PCB unit including an organic substrate. The circuit substrate unit CS10 may be easily manufactured through a PCB manufacturing process. The plurality of circuit substrate units CS10 may be provided by forming circuit layers each including a circuit pattern on a single board substrate and dividing (cutting) the same. The circuit substrate unit CS10 may include the organic substrate, one or more first insulating layers disposed on a first surface of the organic substrate, and one or more second insulating layers disposed on a second surface of the organic substrate, which is opposite the first surface of the organic substrate, and a plurality of conductive via elements and a plurality of conductive pattern layer elements may be formed in and between the organic substrate, the one or more first insulating layers, and the one or more second insulating layers. The specific configuration of the circuit substrate unit CS10 may be the same as described with reference to FIG. 2. The plurality of circuit substrate units CS10 may be pre-manufactured according to circuit substrate manufacturing technology.

Referring to FIG. 8B, the plurality of circuit substrate units CS10 may be disposed on a carrier substrate T15 so as to be spaced apart from each other in the horizontal direction. The plurality of circuit substrate units CS10 may be disposed in each of a plurality of two-dimensionally disposed unit package areas U10. For example, one circuit substrate unit CS10 may be disposed in each of the plurality of unit package areas U10, or one or more circuit substrate units CS10 may be disposed in each of the plurality of unit package areas U10. An adhesive layer A15 may be provided on the carrier substrate T15, and the plurality of circuit substrate units CS10 may be attached to the adhesive layer A15. In other words, the plurality of circuit substrate units CS10 may be attached to the carrier substrate T15 in the state in which the adhesive layer A15 is interposed therebetween. The carrier substrate T15 may be a panel or a wafer. The adhesive layer A15 may be an adhesive film. The adhesive layer A15 may be a part of the carrier substrate T15.

In the step of disposing the plurality of circuit substrate units CS10 on the carrier substrate T15, at least one first passive device member PV10 may be disposed on the carrier substrate T15 around the circuit substrate unit CS10 in each of the plurality of unit package areas U10. The first passive device member PV10 may be attached to the adhesive layer A15. As a non-limiting example, the first passive device member PV10 may be a capacitor or may include a capacitor.

Referring to FIG. 8C, a molding layer M15 that forms a single substrate shape along with the plurality of circuit substrate units CS10 while filling the spaces between and around the plurality of circuit substrate units CS10 may be formed on the carrier substrate T15. If the first passive device member PV10 is disposed on the carrier substrate T15, the molding layer M15 may be formed so as to cover the first passive device member PV10. The molding layer M15 may include a polymer material. For example, the molding layer M15 may include a molding compound. The plurality of circuit substrate units CS10 and the molding layer M15 may constitute a package substrate S150. In other words, the package substrate S150 may include a plurality of circuit substrate units CS10 and a molding layer M15.

Referring to FIG. 8D, a redistribution layer member R15 may be formed on a first surface of the package substrate S150 including the plurality of circuit substrate units CS10 and the molding layer M15. The first surface of the package substrate S150 may be any one of two main surfaces (an upper surface and a lower surface) of the package substrate S150. The redistribution layer member R15 may serve to redistribute an electrode pad array of the circuit substrate unit CS10. The redistribution layer member R15 may be formed through processes such as forming an insulating layer having a via hole (opening), forming a seed layer, forming a mask pattern, electroplating a wiring layer, and removing the mask pattern. Although the redistribution layer member R15 is simply shown, the redistribution layer member R15 may include a structure in which an insulating layer (e.g., an organic insulating layer) and a wiring member layer (wiring element layer) are alternately stacked at least once. The insulating layer may have a plurality of via holes (openings) formed therein, and conductive via elements may be provided in the via holes. The conductive via element may serve as a vertical wire.

The redistribution layer member R15 may include a plurality of electrode pads P10 exposed on the surface thereof. The plurality of electrode pads P10 may be disposed on the opposite side of the package substrate S150, and may be disposed in two dimensions. In each of the plurality of unit package areas U10, the electrode pads P10 may be electrically connected to the circuit substrate unit CS10. In addition, the redistribution layer member R15 may be electrically connected to the first passive device member PV10. The redistribution layer member R15 may be in contact with the first passive device member PV10.

If necessary, the carrier substrate T15 (FIG. 8C) may be removed from the plurality of circuit substrate units CS10 and the molding layer M15 in this step. At this time, the adhesive layer A15 (FIG. 8C) may also be removed. As a non-limiting example, after forming the molding layer M15, the carrier substrate T15 (FIG. 8C) and the adhesive layer A15 (FIG. 8C) may be removed, and then the redistribution layer member R15 may be formed. The redistribution layer member R15 may be formed on the surface of the package substrate S150 exposed by removing the carrier substrate T15 (FIG. 8C) and the adhesive layer A15 (FIG. 8C). However, this process is only illustrative and may be modified in various ways. The timing of removal of the carrier substrate T15 (FIG. 8C) may vary.

Referring to FIG. 8E, in each of the plurality of unit package areas U10, a plurality of chips C10 may be mounted on the redistribution layer member R15 so as to be electrically connected to the redistribution layer member R15. According to an example, a plurality of bumps B10 may be provided on one surface of each of the plurality of chips C10. In other words, each of the plurality of chips C10 may include a plurality of bumps B10 disposed on one surface thereof. Each of the plurality of bumps B10 may be a micro bump, and may have at least a partial ball shape or other shapes. Each of the plurality of bumps B10 may be a type of electrical connection element. The plurality of chips C10 may be mounted on the redistribution layer member R15 such that the plurality of bumps B10 is electrically connected to the redistribution layer member R15. As the plurality of bumps B10 is connected to the plurality of electrode pads P10, the chip C10 may be electrically connected to the circuit substrate unit CS10 via the redistribution layer member R15.

According to an embodiment, the plurality of chips C10 may include heterogeneous chips. For example, the plurality of chips C10 may include a memory chip and a logic chip, and may further include other types of chips. In each of the plurality of unit package areas U10, the plurality of chips C10 may be disposed on the redistribution layer member R15 so as to be spaced apart from each other in the horizontal direction, and in some cases, one or more chips (i.e., dies) may be further stacked (mounted) on at least one of the plurality of chips C10.

Referring to FIG. 8F, in each of the plurality of unit package areas U10, a plurality of electrical connection elements E10 may be formed on a second surface of the package substrate S150, which is opposite the first surface of the package substrate S150. The second surface of the package substrate S150 may be any one of the two main surfaces (the upper surface and the lower surface) of the package substrate S150. The plurality of electrical connection elements E10 may be disposed so as to be electrically connected to or to be in electrical contact with the plurality of circuit substrate units CS10. As a non-limiting example, each of the plurality of electrical connection elements E10 may include a solder ball or a bump.

In each of the plurality of unit package areas U10, at least one second passive device member PV20 may be further formed on the second surface of the package substrate S150. The second passive device member PV20 may be electrically connected to the circuit substrate unit CS10. The second passive device member PV20 may be attached to the second surface of the package substrate S150 together with the plurality of electrical connection elements E10 so as to be electrically connected to or in electric contact with the circuit substrate unit CS10. As a non-limiting example, the second passive device member PV20 may be a capacitor or may include a capacitor.

A device structure D100 including the plurality of circuit substrate units CS10, the molding layer M15, the redistribution layer member R15, and the plurality of chips C10 may be defined. The device structure D100 may further include a plurality of electrical connection elements E10. The device structure D100 may include a plurality of package device areas.

Referring to FIG. 8G, the device structure D100 (FIG. 8F) may be divided (cut) into individual package devices corresponding to each of the plurality of unit package areas U10. This may be performed using a general dividing (cutting) method. As a result, it is possible to obtain individual semiconductor package devices D10a, D10b, and D10c. Each of the semiconductor package devices D10a, D10b, and D10c may have the same configuration as described with reference to FIG. 1.

According to the embodiment of the present invention, the semiconductor package device may be manufactured using a method similar to a fan-out packaging method. For example, the semiconductor package device may be manufactured using a method similar to a fan-out panel level packaging (FOPLP) method or a fan-out wafer level packaging (FOWLP) method. As a specific example, a plurality of circuit substrate units may be attached to a predetermined carrier substrate, a molding layer configured to fix the plurality of circuit substrate units may be formed on the carrier substrate, a redistribution layer member electrically connected to the plurality of circuit substrate units may be formed, and a plurality of chips may be mounted on the redistribution layer member. The plurality of circuit substrate units may be attached to the carrier substrate, for example, in a face-down manner or a face-up manner. In addition, an RDL-last method or an RDL-first method may be used when manufacturing the semiconductor package device.

According to the embodiment of the present invention described above, it is possible to implement a method of manufacturing a semiconductor package device capable of increasing cost-effectiveness and productivity and improving device performance. In addition, it is possible to implement a semiconductor package device that is easy to respond to various design changes, is easy to manufacture, and is capable of securing excellent electrical performance and a method of manufacturing the same. For example, it is possible to easily manufacture a semiconductor package device that interconnects heterogeneous chips using a fan-out packaging process including a PCB process and a redistribution layer (RDL) process.

According to another embodiment, an initial molding layer configured to cover the plurality of circuit substrate units CS10 may be formed in the step of FIG. 8C. The height of the initial molding layer may be greater than the height of the circuit substrate unit CS10. In other words, the initial molding layer may be formed to a larger thickness than the circuit substrate unit CS10 so as to cover the plurality of circuit substrate units CS10. Therefore, an upper surface of the circuit substrate unit CS10 may be covered by the initial molding layer. Subsequently, a grinding or ablation process may be performed on the initial molding layer to expose one surface of each of the plurality of circuit substrate units CS10. As a result, the surface of the molding layer obtained through the grinding or ablation process and the surface of the circuit substrate unit CS10 may form the same (essentially the same) plane. The grinding or ablation process may be performed in the step of FIG. 8C or at an appropriate time after the step of FIG. 8C.

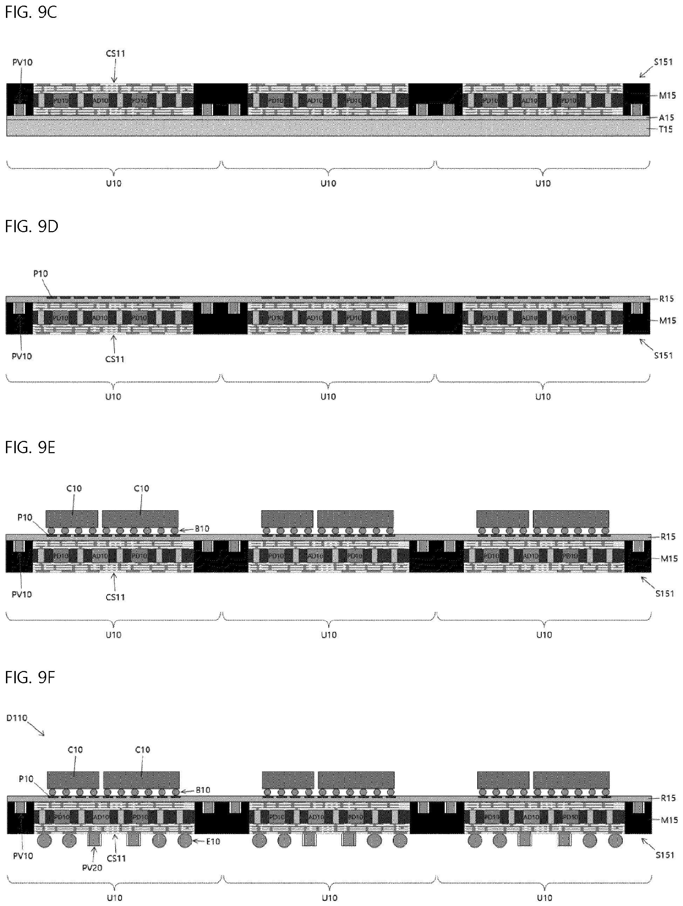

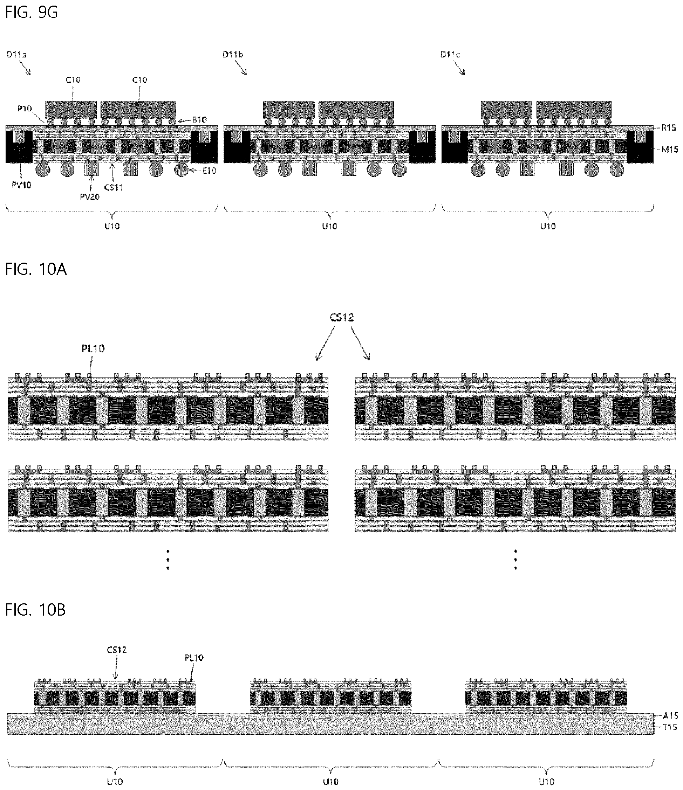

FIGs. 9A, 9B, 9C, 9D, 9E, 9F and 9G are sectional views illustratively showing a method of manufacturing a semiconductor package device according to another embodiment of the present invention. In this embodiment, the circuit substrate unit CS11 described with reference to FIG. 4 may be used. The manufacturing method according to this embodiment may be identical to the manufacturing method according to the embodiment of FIGs. 8A, 8B, 8C, 8D, 8E, 8F and 8G except for the configuration of the circuit substrate unit CS11.

In a step of FIG. 9A, a plurality of circuit substrate units CS11 may be provided. Each of the plurality of circuit substrate units CS11 may include a plurality of conductive via elements extending in the vertical direction and a plurality of conductive pattern layer elements extending in the horizontal direction. For example, the circuit substrate unit CS10 may be a PCB unit including an organic substrate. In this embodiment, the circuit substrate unit CS11 may include at least one embedded passive device element PD10 and/or at least one embedded active device element AD10. The circuit substrate unit CS11 may include both at least one embedded passive device element PD10 and at least one embedded active device element AD10. As a non-limiting example, the passive device element PD10 may include a capacitor, a resistor, an inductor, and an integrated passive device (IPD). As a non-limiting example, the active device element AD10 may include a transistor, a diode, an operational amplifier, and an integrated circuit (IC). The plurality of circuit substrate units CS10 may be pre-manufactured according to circuit substrate manufacturing technology.

The steps of FIGs. 9B to 9G may correspond to the steps of FIGs. 8B to 8G, respectively, and therefore a detailed description thereof will be omitted. Reference symbol S151 indicates a package substrate, reference symbol D110 indicates a device structure, and reference symbols D11a, D11b, and D11c indicate semiconductor package devices. Each of the semiconductor package devices D11a, D11b, and D11c may have the configuration described with reference to FIG. 3. If the circuit substrate unit CS11 includes at least one embedded passive device element PD10 and/or at least one embedded active device element AD10, the electrical performance and functionality of the semiconductor package device may be further improved. In the circuit substrate unit CS11, the positions where the passive device element PD10 and the active device element AD10 are formed/disposed are not limited to those shown and may be changed in various ways.

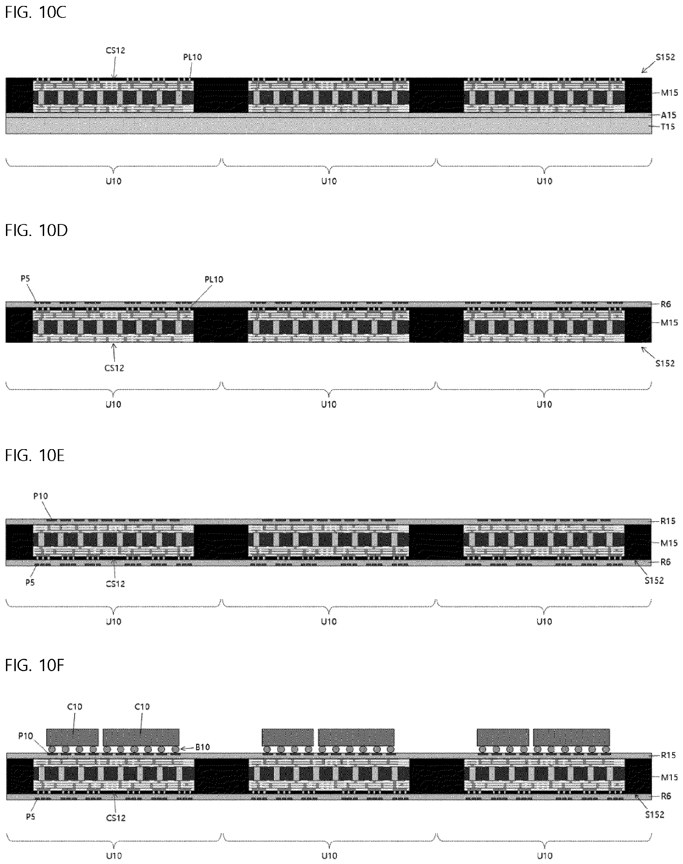

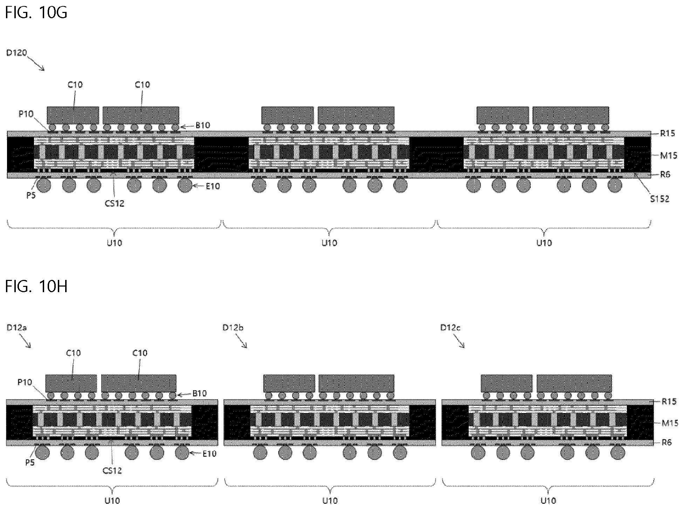

FIGs. 10A, 10B, 10C, 10D, 10E, 10F, 10G and 10H are sectional views illustratively showing a method of manufacturing a semiconductor package device according to yet another embodiment of the present invention. In this embodiment, the circuit substrate unit CS12 described with reference to FIG. 6 may be used.

Referring to FIG. 10A, a plurality of circuit substrate units CS12 may be provided. Each of the plurality of circuit substrate units CS12 may include a plurality of conductive via elements extending in the vertical direction and a plurality of conductive pattern layer elements extending in the horizontal direction. For example, the circuit substrate unit CS12 may be a PCB unit including an organic substrate. In this embodiment, the circuit substrate unit CS12 may include at least one of an antenna, a frequency filter, and a front end module (FEM) for communication. For example, the frequency filter may be an RF filter; however, the present invention is not limited thereto. For example, the FEM for communication may be an RF front end module (FEM); however, the present invention is not limited thereto. The antenna, the frequency filter, and the FEM for communication may be formed using device embedding technology or other device formation technologies. In addition, the circuit substrate unit CS12 may further include a plurality of conductive pillar elements PL10 formed on the surface (one surface) thereof. As a non-limiting example, the plurality of conductive pillar elements PL10 may include a metal, such as copper (Cu), or a metallic material. The plurality of circuit substrate units CS12 may be pre-manufactured according to circuit substrate manufacturing technology.

Referring to FIG. 10B, the plurality of circuit substrate units CS12 may be disposed on a carrier substrate T15 so as to be spaced apart from each other in the horizontal direction. The plurality of circuit substrate units CS12 may be disposed in each of a plurality of two-dimensionally disposed unit package areas U10. An adhesive layer A15 may be provided on the carrier substrate T15, and the plurality of circuit substrate units CS12 may be attached to the adhesive layer A15. The adhesive layer A15 may be a part of the carrier substrate T15.

Referring to FIG. 10C, a molding layer M15 that forms a single substrate shape along with the plurality of circuit substrate units CS12 while filling the spaces between and around the plurality of circuit substrate units CS12 may be formed on the carrier substrate T15. The molding layer M15 may be formed so as to fill the spaces between and around the plurality of conductive pillar elements PL10, and an end of each of the plurality of conductive pillar elements PL10 may be exposed without being covered by the molding layer M15. Therefore, one surface of the circuit substrate unit CS12 having the plurality of conductive pillar elements PL10 formed thereon may be exposed by the molding layer M10. The plurality of circuit substrate units CS12 and the molding layer M15 may constitute a single package substrate S152. In other words, the package substrate S152 may include a plurality of circuit substrate units CS12 and a molding layer M15.

Referring to FIG. 10D, a redistribution layer member R6 may be formed on one surface of the package substrate S152 including the plurality of circuit substrate units CS12 and the molding layer M15. For convenience, the redistribution layer member R6 is referred to as a "separate redistribution layer member R6." The separate redistribution layer member R6 may be formed so as to be electrically connected to the plurality of conductive pillar elements PL10. The separate redistribution layer member R6 may include a plurality of electrode pads P5 exposed on the surface thereof. The plurality of electrode pads P5 may be disposed on the opposite side of the package substrate S152, and may be disposed in two dimensions. At least some of the plurality of electrode pads P5 may be electrically connected to the plurality of circuit substrate units CS12.

In this step, the carrier substrate T15 (FIG. 10C) may be removed from the plurality of circuit substrate units CS12 and the molding layer M15. At this time, the adhesive layer A15 (FIG. 10C) may also be removed.

Referring to FIG. 10E, a redistribution layer member R15 may be formed on the other surface of the package substrate S152 including the plurality of circuit substrate units CS12 and the molding layer M15. The redistribution layer member R15 may be formed on the surface of the package substrate S152 exposed by removing the carrier substrate T15 (FIG. 10C) and the adhesive layer A15 (FIG. 10C). The redistribution layer member R15 may include a plurality of electrode pads P10 exposed on the surface thereof. The plurality of electrode pads P10 may be disposed on the opposite side of the package substrate S152, and may be disposed in two dimensions.

Referring to FIG. 10F, in each of the plurality of unit package areas U10, a plurality of chips C10 may be mounted on the redistribution layer member R15 so as to be electrically connected to the redistribution layer member R15. According to an example, a plurality of bumps B10 may be provided on one surface of each of the plurality of chips C10. The plurality of chips C10 may be mounted on the redistribution layer member R15 such that the plurality of bumps B10 is electrically connected to the redistribution layer member R15. As the plurality of bumps B10 is connected to the plurality of electrode pads P10, the chip C10 may be electrically connected to the circuit substrate unit CS12 via the redistribution layer member R15.

Referring to FIG. 10G, in each of the plurality of unit package areas U10, a plurality of electrical connection elements E10 may be disposed on one surface of the separate redistribution layer member R5 so as to be electrically connected to the separate redistribution layer member R5. The plurality of electrical connection elements E10 may be disposed at one surface of the package substrate S152 that is opposite the side on which the plurality of chips C10 is disposed. The plurality of electrical connection elements E10 may be connected to or in contact with the plurality of electrode pads P5.

A device structure D120 including the plurality of circuit substrate units CS12, the molding layer M15, the redistribution layer member R15, and the plurality of chips C10 may be defined. The device structure D120 may further include a separate redistribution layer member R6 and a plurality of electrical connection elements E10. The device structure D120 may include a plurality of package device areas.

Referring to FIG. 10H, the device structure D120 (FIG. 10G) may be divided (cut) into individual package devices corresponding to each of the plurality of unit package areas U10. As a result, it is possible to obtain individual semiconductor package devices D12a, D12b, and D12c. Each of the semiconductor package devices D12a, D12b, and D12c may have the same configuration as described with reference to FIG. 6. If the circuit substrate unit CS12 includes at least one of an antenna, a frequency filter, and a FEM for communication, the electrical performance and functionality of the semiconductor package device may be further improved.

Although the methods of manufacturing the semiconductor package devices according to the embodiments has been described in detail with reference to FIGs. 9A, 9B, 9C, 9D, 9E, 9F and 9G, and 10A, 10B, 10C, 10D, 10E, 10F, 10G and 10H, the methods of manufacturing the semiconductor package devices according to the embodiments may be varied as needed.

According to embodiments of the present invention, it is possible to implement a semiconductor package device capable of increasing cost-effectiveness and productivity and improving device performance and a method of manufacturing the same. In addition, according to embodiments of the present invention, it is possible to implement a semiconductor package device that is easy to respond to various design changes, is easy to manufacture, and is capable of securing excellent electrical performance and a method of manufacturing the same.

According to an embodiment, it is possible to implement a cost-effective and highly productive method capable of manufacturing a semiconductor package device that interconnects heterogeneous chips using, for example, a fan-out packaging process including a printed circuit board (PCB) process and a redistribution layer (RDL) process. According to an embodiment, it is possible to improve the electrical performance of a package device that interconnects heterogeneous chips, improve process efficiency, and improve ease of design changes using, for example, a circuit substrate unit including an embedded passive device element and an embedded active device element. According to an embodiment, it is possible to improve the electrical performance of a package device that interconnects heterogeneous chips using, for example, a circuit substrate unit including at least one of an antenna, a frequency filter, and a front end module (FEM) for communication. The technology according to the embodiments may be usefully applied to various advanced packaging fields.

However, the effects of the present invention are not limited to the above effects, and may be variously expanded without departing from the technical ideas and scope of the present invention.

Preferred embodiments of the present invention have been disclosed herein, and although certain terms are used, they are used in a general sense to facilitate the description and understanding of the invention, and are not intended to limit the scope of the invention. In addition to the embodiments disclosed herein, other modifications based on the technical ideas of the present invention will be apparent to those skilled in the art to which the present invention pertains. It will be apparent to those skilled in the art that the semiconductor package device and the method of manufacturing the same according to the embodiments described with reference to FIGs. 1 to 10H may be subject to various substitutions, changes, and modifications without departing from the technical ideas of the present invention. For example, the specific configuration of a circuit substrate unit may be changed in various ways. The scope of the invention is therefore not to be defined by the embodiments described above but by the technical ideas recited in the appended claims.

## Claims

1. A semiconductor package device comprising:
a circuit substrate unit comprising a plurality of conductive via elements extending in a vertical direction and a plurality of conductive pattern layer elements extending in a horizontal direction;
a molding layer configured to form a single substrate shape along with the circuit substrate unit while filling a space around the circuit substrate unit, the molding layer being disposed so as to expose the circuit substrate unit;
a redistribution layer member disposed on a first surface of a package substrate comprising the circuit substrate unit and the molding layer; and
a plurality of chips mounted on the redistribution layer member so as to be electrically connected to the redistribution layer member.

2. The semiconductor package device according to claim 1, wherein the circuit substrate unit is a printed circuit board (PCB) unit comprising an organic substrate.

3. The semiconductor package device according to claim 2, wherein
the circuit substrate unit comprises the organic substrate, one or more first insulating layers disposed on a first surface of the organic substrate, and one or more second insulating layers disposed on a second surface of the organic substrate, the second surface being opposite the first surface, and
a plurality of conductive via elements and a plurality of conductive pattern layer elements are formed in and between the organic substrate, the one or more first insulating layers, and the one or more second insulating layers.

4. The semiconductor package device according to claim 1, wherein the circuit substrate unit comprises at least one of at least one embedded passive device element and at least one embedded active device element.

5. The semiconductor package device according to claim 1, wherein the circuit substrate unit comprises at least one of an antenna, a frequency filter, and a front end module (FEM) for communication.

6. The semiconductor package device according to claim 1, wherein
a plurality of bumps is provided on one surface of each of the plurality of chips, and
the plurality of chips is mounted on the redistribution layer member such that the plurality of bumps is electrically connected to the redistribution layer member.

7. The semiconductor package device according to claim 1, wherein the plurality of chips comprises heterogeneous chips.

8. The semiconductor package device according to claim 1, wherein a plurality of electrical connection elements electrically connected to the circuit substrate unit is disposed on a second surface of the package substrate, the second surface being opposite the first surface.

9. The semiconductor package device according to claim 1, further comprising:
a separate redistribution layer member disposed on a second surface of the package substrate, the second surface being opposite the first surface; and
a plurality of electrical connection elements disposed on the separate redistribution layer member so as to be electrically connected to the separate redistribution layer member.

10. The semiconductor package device according to claim 1, further comprising at least one of:
at least one first passive device member disposed in the molding layer around the circuit substrate unit, the at least one first passive device member being electrically connected to the redistribution layer member; and
at least one second passive device member disposed on a second surface of the package substrate, the second surface being opposite the first surface, so as to be electrically connected to the circuit substrate unit.

11. A method of manufacturing a semiconductor package device, the method comprising:
providing a plurality of circuit substrate units each comprising a plurality of conductive via elements extending in a vertical direction and a plurality of conductive pattern layer elements extending in a horizontal direction;
disposing the plurality of circuit substrate units on a carrier substrate so as to be spaced apart from each other in the horizontal direction, the plurality of circuit substrate units being disposed in each of a plurality of two-dimensionally disposed unit package areas;
forming a molding layer configured to form a single substrate shape along with the plurality of circuit substrate units while filling spaces between and around the plurality of circuit substrate units on the carrier substrate;
forming a redistribution layer member on a first surface of a package substrate comprising the plurality of circuit substrate units and the molding layer;
mounting a plurality of chips on the redistribution layer member so as to be electrically connected to the redistribution layer member in each of the plurality of unit package areas; and
dividing a device structure comprising the plurality of circuit substrate units, the molding layer, the redistribution layer member, and the plurality of chips, with the carrier substrate being excluded, into individual package devices corresponding to each of the plurality of unit package areas.

12. The method according to claim 11, further comprising:
forming a separate redistribution layer member on a second surface of the package substrate, the second surface being opposite the first surface; and
forming a plurality of electrical connection elements electrically connected to the separate redistribution layer member on the separate redistribution layer member in each of the plurality of unit package areas.

13. The method according to claim 11, further comprising at least one of:
disposing at least one first passive device member on the carrier substrate around the circuit substrate unit in each of the plurality of unit package areas in the step of disposing the plurality of circuit substrate units on the carrier substrate; and
disposing at least one second passive device member electrically connected to the circuit substrate unit on a second surface of the package substrate, the second surface being opposite the first surface, in each of the plurality of unit package areas.

14. The method according to claim 11, further comprising removing the carrier substrate from the plurality of circuit substrate units and the molding layer between the step of forming the molding layer and the step of dividing the device structure into the individual package devices.

15. The method according to claim 11, further comprising:
forming an initial molding layer configured to cover the plurality of circuit substrate units; and
performing a grinding or ablation process on the initial molding layer to expose one surface of each of the plurality of circuit substrate units.
